(19) **Europäisches Patentamt / European Patent Office / Office européen des brevets**

(11) **EP 4 082 047 B1**

(12) **FASCICULE DE BREVET EUROPEEN**

(45) Date de publication et mention de la délivrance du brevet:
**07.05.2025 Bulletin 2025/19**

(21) Numéro de dépôt: **20829948.7**

(22) Date de dépôt: **22.12.2020**

(51) Classification Internationale des Brevets (IPC):
**H10H 20/01** *(2025.01)* **B23K 26/0622** *(2014.01)*
**B23K 26/08** *(2014.01)* **B23K 26/18** *(2006.01)*
**B23K 26/57** *(2014.01)* **H10H 20/80** *(2025.01)*
**B23K 101/42** *(2006.01)* **H10H 20/813** *(2025.01)*

(52) Classification Coopérative des Brevets (CPC):
**B23K 26/0622; B23K 26/08; B23K 26/18;**
**B23K 26/57; H10H 20/019; H10H 20/872;**
B23K 2101/42; H10H 20/8132; H10H 20/8133

(86) Numéro de dépôt international:
**PCT/EP2020/087614**

(87) Numéro de publication internationale:
**WO 2021/130218 (01.07.2021 Gazette 2021/26)**

(54) **DISPOSITIF À COMPOSANTS OPTOÉLECTRONIQUES TRIDIMENSIONNELS POUR DÉCOUPÉ AU LASER ET PROCÉDÉ DE DÉCOUPÉ AU LASER D'UN TEL DISPOSITIF**

DREIDIMENSIONALE OPTOELEKTRONISCHE BAUELEMENTEVORRICHTUNG ZUM LASERSCHNEIDEN UND VERFAHREN ZUM LASERSCHNEIDEN EINER SOLCHEN VORRICHTUNG

THREEDIMENSIONAL OPTOELECTRONIC COMPONENT DEVICE FOR LASER CUTTING AND PROCEDURE FOR LASER CUTTING OF SUCH A DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.12.2019 FR 1915605**

(43) Date de publication de la demande:
**02.11.2022 Bulletin 2022/44**

(73) Titulaire: **Aledia**
**38130 Echirolles (FR)**

(72) Inventeurs:
• **DUPONT, Florian**
  **38000 Grenoble (FR)**
• **JEANNIN, Olivier**
  **38000 Grenoble (FR)**
• **DUPONT, Tiphaine**
  **38000 Grenoble (FR)**
• **DAANOUNE, Mehdi**
  **38340 Voreppe (FR)**

(74) Mandataire: **Cabinet Beaumont**
  **4, Place Robert Schuman**
  **B.P. 1529**
  **38025 Grenoble Cedex 1 (FR)**

(56) Documents cités:
KR-A- 20120 022 207  US-A1- 2006 225 644
US-A1- 2015 279 903  US-A1- 2019 363 069

## Description

La présente demande de brevet revendique la priorité de la demande de brevet français FR19/15605.

Domaine technique

La présente description concerne de façon générale les dispositifs à composants optoélectroniques tridimensionnels pour découpe au laser et les procédés de découpe au laser de tels dispositifs.

Technique antérieure

Pour certaines applications, il est souhaitable de pouvoir réaliser une découpe au laser d'un objet présent sur un premier support sensiblement transparent au laser, au travers du support, par exemple pour détacher l'objet du premier support et le transférer sur un deuxième support. Dans ce but, une couche absorbante pour le laser est généralement interposée entre l'objet à détacher et le premier support et le faisceau laser est focalisé sur cette couche absorbante, l'ablation de la couche absorbante entraînant le détachement de l'objet par rapport au premier support. La couche absorbante correspond par exemple à une couche métallique, notamment une couche d'or.

Dans le cas où l'objet est un circuit optoélectronique, il peut être souhaitable que le premier support corresponde au substrat sur lequel est formé le circuit optoélectronique. Ceci permet d'éviter de devoir reporter le circuit optoélectronique sur le premier support. Dans ce cas, la couche absorbante correspond à une couche qui est formée avec le circuit optoélectronique. Toutefois, lorsque le circuit optoélectronique comprend des composants optoélectroniques tridimensionnels, notamment des diodes électroluminescentes tridimensionnelles, le procédé de formation de ces composants optoélectroniques tridimensionnels peut imposer des contraintes supplémentaires sur la couche absorbante. En effet, le procédé de formation des composants optoélectroniques tridimensionnels peut comprendre des étapes de croissance par épitaxie d'éléments semiconducteurs tridimensionnels qui ne peuvent pas être mises en oeuvre directement sur une couche absorbante métallique, notamment en raison des températures nécessaires pour les étapes d'épitaxie. Il peut néanmoins être difficile de réaliser une couche absorbante en un matériau non métallique qui soit compatible avec la croissance par épitaxie d'éléments semiconducteurs tridimensionnels sur cette couche, et qui ait en outre les propriétés d'absorption souhaitées. Cela peut notamment être le cas lorsque l'épaisseur de la couche absorbante est limitée, notamment pour des raisons de coûts ou pour des raisons de faisabilité technologique. Il peut alors être nécessaire d'augmenter la puissance du laser utilisé pour obtenir l'ablation de la couche absorbante, ce qui peut entraîner la détérioration des régions voisines de la couche absorbante, notamment des régions faisant partie du circuit optoélectronique à détacher, ce qui n'est pas souhaitable. Les documents US 2019/363069 A1 et US 2015/279903 A1 décrivent des procédés de fabrication d'un dispositif optoélectronique comprenant la formation de diodes électroluminescentes.

Résumé de l'invention

Ainsi, un objet d'un mode de réalisation est de pallier au moins en partie les inconvénients des dispositifs à composants optoélectroniques tridimensionnels décrits précédemment pour découpe au laser et les procédés décrits précédemment de découpe au laser de tels dispositifs.

Un objet d'un mode de réalisation est que le faisceau laser soit focalisé sur une région à enlever du dispositif au travers d'une partie du dispositif.

Un autre objet d'un mode de réalisation est que les zones voisines de la région à enlever ne soient pas abimées par le traitement.

Un autre objet d'un mode de réalisation est que le procédé de fabrication du dispositif ne comprenne pas d'étape de report d'un élément sur un autre.

Un autre objet d'un mode de réalisation est que le procédé de fabrication du dispositif comprenne des étapes de dépôts par épitaxie.

Selon l'invention, un dispositif tel que défini dans la revendication 1 est divulgué.

Selon un mode de réalisation, la région absorbante comprend un cristal photonique.

Selon un mode de réalisation, le cristal photonique est un cristal photonique à deux dimensions.

Selon un mode de réalisation, chaque pilier s'étend dans la couche de base sur au moins une partie de l'épaisseur de la couche de base.

Selon un mode de réalisation, le premier matériau a un coefficient d'absorption pour le laser inférieur à 1.

Selon un mode de réalisation, le premier matériau a un coefficient d'absorption pour le laser compris entre 1 et 10.

Selon un mode de réalisation, le deuxième matériau a un coefficient d'absorption pour le laser inférieur à 1.

Selon un mode de réalisation, la région absorbante comprend une couche absorbante entourant la base, la couche absorbante étant en un troisième matériau ayant un coefficient d'absorption pour le laser compris entre 1 et 10.

Selon un mode de réalisation, le dispositif comprend une couche isolante électriquement interposée entre la couche absorbante et le support.

Selon un mode de réalisation, le dispositif comprend une couche isolante électriquement interposée entre la couche absorbante et l'élément semiconducteur tridimensionnel.

Selon un mode de réalisation, la région absorbante entoure le plot.

Selon un mode de réalisation, le deuxième matériau est un nitrure, un carbure ou un borure d'un métal de transition de la colonne IV, V ou VI du tableau périodique des éléments ou une combinaison de ces composés ou le deuxième matériau est du nitrure d'aluminium, de l'oxyde d'aluminium, du bore, du nitrure de bore, du titane, du nitrure de titane, du tantale, du nitrure de tantale, de l'hafnium, du nitrure d'hafnium, du niobium, du nitrure de niobium, du zirconium, du borate de zirconium, du nitrure de zirconium, du carbure de silicium, du nitrure et carbure de tantale, du nitrure de magnésium ou un mélange d'au moins deux de ces composés.

Selon un mode de réalisation, le support comprend des première et deuxième faces opposées, le laser étant destiné à traverser le support de la première face à la deuxième face, la région absorbante recouvrant au moins en partie la deuxième face.

Selon un mode de réalisation, le dispositif comprend plusieurs exemplaires du composant optoélectronique, les bases desdits composants optoélectroniques étant fixées au support.

Un mode de réalisation prévoit également un procédé de fabrication du dispositif tel que défini précédemment, comprenant la croissance par épitaxie de l'élément semiconducteur tridimensionnel sur le support.

Un mode de réalisation prévoit également un procédé de traitement au laser du dispositif tel que défini précédemment, le procédé comprenant l'exposition de la région absorbante au faisceau laser au travers du support.

Selon un mode de réalisation, le procédé comprend la fixation du circuit optoélectronique à un réceptacle, le circuit optoélectronique étant encore relié au support et la destruction d'au moins une partie de la région absorbante par le laser.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 illustre un mode de réalisation d'un système de traitement au laser d'un dispositif comprenant une région absorbante ;

la figure 2 est une vue agrandie, partielle et schématique, d'un mode de réalisation de la région absorbante du dispositif de la figure 1; cette configuration ne relève pas du champ de l'invention telle que revendiquée;

la figure 3 est une vue agrandie, partielle et schématique, d'un autre mode de réalisation de la région absorbante du dispositif de la figure 1; cette configuration relève du champ de l'invention telle que revendiquée ;

la figure 4 est une vue de dessus avec coupe, partielle et schématique, du dispositif représenté en figure 3 ;

la figure 5 est une vue agrandie, partielle et schématique, d'un autre mode de réalisation de la région absorbante du dispositif de la figure 1; cette configuration relève du champ de l'invention telle que revendiquée ;

la figure 6 représente un agencement des piliers du cristal photonique de la région absorbante du dispositif de la figure 3 ou 5 ;

la figure 7 représente un autre agencement des piliers du cristal photonique de la région absorbante du dispositif de la figure 3 ou 5 ;

la figure 8 représente une courbe d'évolution de l'absorption de la région absorbante du dispositif de la figure 5 en fonction du rapport entre les pas des piliers du cristal photonique et la longueur d'onde du laser incident ;

la figure 9 représente une carte en niveaux de gris de l'absorption de la région absorbante du dispositif de la figure 5 en fonction du facteur de remplissage des piliers et du rapport entre le pas des piliers du cristal photonique et la longueur d'onde du laser incident ;

la figure 10 représente une autre carte en niveaux de gris de l'absorption de la région absorbante du dispositif de la figure 5 en fonction du facteur de remplissage des piliers et du rapport entre le pas des piliers du cristal photonique et la longueur d'onde du laser incident ;

la figure 11 représente une courbe d'évolution de l'absorption de la région absorbante du dispositif de la figure 5 en fonction de la hauteur des piliers de la couche de cristal photonique pour des premières valeurs du facteur de remplissage des piliers et du rapport entre le pas des piliers du cristal photonique et la longueur d'onde du laser incident ;

la figure 12 représente une courbe d'évolution de l'absorption de la région absorbante du dispositif de la figure 5 en fonction de la hauteur des piliers de la couche de cristal photonique pour des deuxièmes valeurs du facteur de remplissage des piliers et du rapport entre les pas des piliers du cristal photonique et la longueur d'onde du laser incident ;

la figure 13 est une vue en coupe, partielle et schématique, d'un mode de réalisation d'un composant optoélectronique du dispositif de la figure 1 ;

la figure 14 est une vue en coupe, partielle et schématique, d'un autre mode de réalisation d'un composant optoélectronique du dispositif de la figure 1 ;

la figure 15 représente la structure obtenue à une étape d'un mode de réalisation d'un procédé de découpe au laser du dispositif de la figure 1 ;

la figure 16 représente la structure obtenue à une autre étape du procédé de découpe au laser ;

la figure 17 représente la structure obtenue à une autre étape du procédé de découpe au laser ;

la figure 18 représente la structure obtenue à une

autre étape du procédé de découpe au laser ;

la figure 19 représente la structure obtenue à une étape d'un mode de réalisation d'un procédé de fabrication du dispositif de la figure 5 ;

la figure 20 représente la structure obtenue à une autre étape du procédé de fabrication ;

la figure 21 représente la structure obtenue à une autre étape du procédé de fabrication ;

la figure 22 représente la structure obtenue à une autre étape du procédé de fabrication ;

la figure 23 représente la structure obtenue à une autre étape du procédé de fabrication ;

la figure 24 représente la structure obtenue à une autre étape du procédé de fabrication ; et

la figure 25 représente la structure obtenue à une autre étape du procédé de fabrication.

Description des modes de réalisation

**[0028]** De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les étapes et éléments utiles à la compréhension des modes de réalisation décrits ont été représentés et sont détaillés. En particulier, les sources laser sont bien connues de l'homme du métier et ne sont pas détaillées par la suite.

**[0029]** Dans la description qui suit, lorsque l'on fait référence à des qualificatifs de position absolue, tels que les termes "avant", "arrière", "haut", "bas" , "gauche", "droite", etc., ou relative, tels que les termes "dessus", "dessous", "supérieur", "inférieur", etc., il est fait référence sauf précision contraire à l'orientation des figures. Sauf précision contraire, les expressions "environ", "approximativement", "sensiblement", et "de l'ordre de" signifient à 10 % près, de préférence à 5 % près. En outre, on considère ici que les termes "isolant" et "conducteur" signifient respectivement "isolant électriquement" et "conducteur électriquement".

**[0030]** Dans la suite de la description, la transmittance interne d'une couche correspond au rapport entre l'intensité du rayonnement sortant de la couche et l'intensité du rayonnement entrant dans la couche. L'absorption de la couche est égale à la différence entre 1 et la transmittance interne. Dans la suite de la description, une couche est dite transparente à un rayonnement lorsque l'absorption du rayonnement au travers de la couche est inférieure à 60 %. Dans la suite de la description, une couche est dite absorbante à un rayonnement lorsque l'absorption du rayonnement dans la couche est supérieure à 60 %. Dans la suite de la description, on considère qu'un laser correspond à un rayonnement monochromatique. En pratique, le laser peut présenter une plage étroite de longueurs d'onde centrée sur une longueur d'onde centrale, appelée longueur d'onde du laser. Dans la suite de la description, l'indice de réfraction d'un matériau correspond à l'indice de réfraction du matériau à la longueur d'onde du laser utilisé pour le traitement au laser. On appelle coefficient d'absorption k, la partie imaginaire de l'indice optique du matériau concerné. Il est relié à l'absorption linéique $\alpha$ du matériau selon la relation

**[0031]** Des modes de réalisation vont être décrits pour la découpe au laser de circuits optoélectroniques formés sur un substrat. Par circuits optoélectroniques, on entend des circuits comprenant des composants optoélectroniques adaptés à effectuer la conversion d'un signal électrique en un rayonnement électromagnétique ou inversement, et notamment des circuits dédiés à la détection, la mesure ou l'émission d'un rayonnement électromagnétique ou des circuits dédiés à des applications photovoltaïques.

**[0032]** On s'intéresse plus particulièrement ici à des circuits optoélectroniques comprenant des composants optoélectroniques tridimensionnels, c'est-à-dire des composants optoélectroniques comprenant des éléments semiconducteurs tridimensionnels, en particulier de dimensions micrométriques ou nanométriques, et une zone active formée sur la surface de chaque élément tridimensionnel. On appelle zone active du composant optoélectronique la région depuis laquelle est émise la majorité du rayonnement électromagnétique fourni par le composant optoélectronique ou est captée la majorité du rayonnement électromagnétique reçu par le composant optoélectronique. Des exemples d'éléments tridimensionnels sont les microfils, les nanofils, les éléments coniques de taille micrométrique ou nanométrique, ou les éléments tronconiques de taille micrométrique ou nanométrique. Dans la suite de la description, des modes de réalisation sont décrits pour des composants optoélectroniques à microfils ou à nanofils. Toutefois, ces modes de réalisation peuvent être mis en oeuvre pour des éléments tridimensionnels autres que des microfils ou des nanofils, par exemple des éléments tridimensionnels en forme de pyramide.

**[0033]** Le terme "microfil" ou "nanofil" désigne une structure tridimensionnelle de forme allongée selon une direction privilégiée dont au moins deux dimensions, appelées dimensions mineures, sont comprises entre 5 nm et 5 $\mu$m, de préférence entre 50 nm et 2,5 $\mu$m, la troisième dimension, appelée dimension majeure ou hauteur, étant au moins égale à 1 fois, de préférence au moins 5 fois et encore plus préférentiellement au moins 10 fois, la plus grande des dimensions mineures. Dans certains modes de réalisation, les dimensions mineures peuvent être inférieures ou égales à environ 1 $\mu$m, de préférence comprises entre 100 nm et 1 $\mu$m, plus préférentiellement entre 100 nm et 300 nm. Dans certains modes de réalisation, la hauteur de chaque microfil ou nanofil peut être supérieure ou égale à 500 nm, de préférence comprise entre 1 $\mu$m et 50 $\mu$m. Dans la suite de la description, on utilise le terme "fil" pour signifier "microfil ou nanofil" et la direction privilégiée selon la-

quelle s'étend le fil est appelée par la suite "axe" du fil.

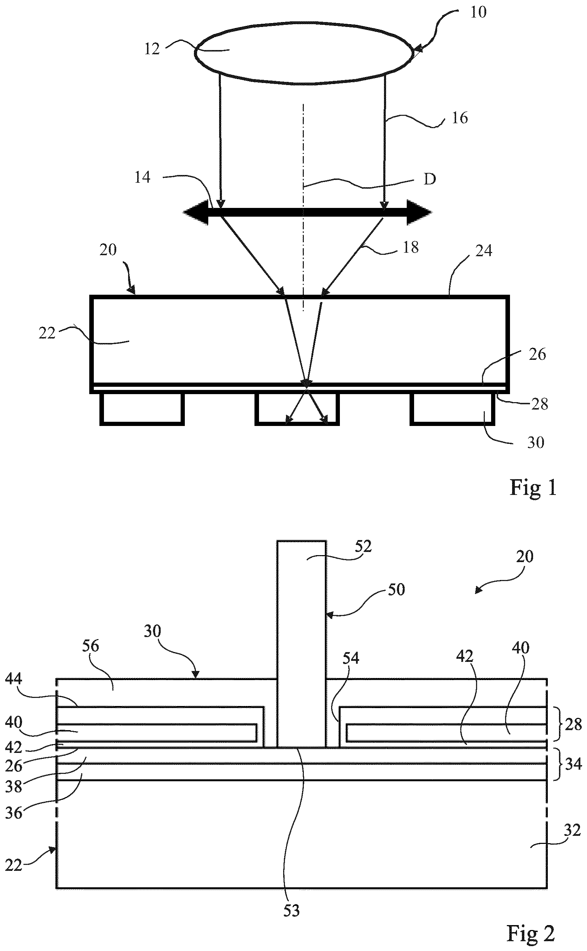

La figure 1 est une vue en coupe, partielle et schématique, d'un mode de réalisation d'un système de découpe 10 au laser d'un dispositif 20.

Le système de découpe 10 comprend une source laser 12 et un dispositif optique de focalisation 14 ayant un axe optique D. La source 12 est adaptée à fournir un faisceau laser incident 16 au dispositif de focalisation 14 qui fournit un faisceau laser 18 convergent. Le dispositif optique de focalisation 14 peut comprendre un composant optique, deux composants optiques ou plus de deux composants optiques, un composant optique correspondant par exemple à une lentille. De préférence, le faisceau laser incident 16 est sensiblement collimaté selon l'axe optique D du dispositif optique 14.

Le dispositif 20 comprend un support 22 comprenant deux faces 24, 26 opposées. Le faisceau laser 18 pénètre dans le support 22 par la face 24. Selon un mode de réalisation, les faces 24 et 26 sont parallèles. Selon un mode de réalisation, les faces 24 et 26 sont planes. L'épaisseur du support 22 peut être comprise entre 50 μm et 3 mm. Une couche antireflet pour le laser, non représentée, peut être prévue sur la face 24 du support 22. Le support 22 peut avoir une structure monocouche ou une structure multicouche. En particulier, le support 22 peut comprendre un substrat monobloc et une couche ou un empilement de couches recouvrant le substrat du côté de la face 26, le substrat correspondant à la plus grande partie de l'épaisseur du support 22, par exemple à plus de 90 % en volume du support 22. Selon un mode de réalisation, le substrat est en un matériau semiconducteur. Le matériau semiconducteur peut être du silicium, du germanium ou un mélange d'au moins deux de ces composés. De préférence, le substrat est en silicium, plus préférentiellement en silicium monocristallin. Selon un autre mode de réalisation, le substrat est, au moins en partie, en un matériau non semiconducteur, par exemple un matériau isolant, notamment du saphir, ou un matériau conducteur.

Le dispositif 20 comprend une région absorbante 28 recouvrant au moins en partie la face 26 et au moins un circuit optoélectronique 30 fixé au support 22 au moins en partie par l'intermédiaire de la région absorbante 28 et que l'on souhaite détacher du support 22. Selon un mode de réalisation, le circuit optoélectronique 30 est au contact de la région absorbante 28 et fixé à la région absorbante 28 du côté de la région absorbante 28 opposée au support 22. A titre d'exemple, plusieurs circuits optoélectroniques 30 sont représentés en figure 1 fixés à la région absorbante 28. En figure 1, la région absorbante 28 est représentée continue sur la face 26. A titre de variante, la région absorbante 28 peut n'être présente qu'entre chaque circuit optoélectronique 30 et le support 22 et ne pas être présente entre les circuits optoélectroniques 30.

Le procédé de découpe peut comprendre le déplacement relatif entre le système de traitement 10 et le dispositif 20 de façon que le faisceau laser 18 balaye la totalité de la région absorbante 28 à enlever. Lors d'une opération de découpe, l'axe optique D du dispositif optique 14 est de préférence perpendiculaire à la face 24.

La longueur d'onde du laser est notamment choisie en fonction du matériau composant le substrat du support 22 pour que le substrat soit transparent pour le laser.

Selon un mode de réalisation, notamment lorsque le substrat du support 22 est semiconducteur, la longueur d'onde du faisceau laser 18 est supérieure à la longueur d'onde correspondant à l'écart de bandes (bandgap) du matériau composant le substrat du support 22, de préférence d'au moins 500 nm, plus préférentiellement d'au moins 700 nm. Ceci permet de façon avantageuse de réduire les interactions entre le faisceau laser 18 et le substrat lors de la traversée du substrat par le faisceau laser 18. Selon un mode de réalisation, la longueur d'onde du faisceau laser 18 est inférieure à la somme de 2500 nm et de la longueur d'onde correspondant à l'écart de bandes (bandgap) du matériau composant le substrat. Ceci permet de façon avantageuse de pouvoir fournir plus facilement un faisceau laser formant un spot laser de faibles dimensions.

Dans le cas où le substrat du support 22 est semiconducteur, le laser peut être un laser infrarouge, la longueur d'onde du faisceau laser 18 pouvant être comprise entre 200 nm et 10 μm. En particulier, dans le cas où le substrat du support 22, est en silicium qui a un écart de bandes de 1,14 eV, ce qui correspond à une longueur d'onde de 1,1 μm, la longueur d'onde du faisceau laser 18 est choisie égale à environ 2 μm. Dans le cas où le substrat du support 22 est en germanium qui a un écart de bandes de 0,661 eV, ce qui correspond à une longueur d'onde de 1,87 μm, la longueur d'onde du faisceau laser 18 est choisie égale à environ 2 μm ou 2,35 μm.

Dans le cas où le substrat du support 22 est en saphir, la longueur d'onde du faisceau laser 18 peut être comprise entre 300 nm et 5 μm.

Selon un mode de réalisation, le faisceau laser 18 est émis par le système de traitement 10 sous la forme d'une impulsion, de deux impulsions ou plus de deux impulsions, chaque impulsion ayant une durée comprise entre 0,1 ps et 1000 ns. La puissance crête du faisceau laser pour chaque impulsion est comprise entre 10 kW et 100 MW.

La figure 2 est une vue en coupe agrandie d'un mode de réalisation du dispositif 20 ; cette configuration ne relève pas du champ de l'invention telle que revendiquée.

Le support 22 du dispositif 20 comprend de bas en haut en figure 2 :

- un substrat 32 ; et
- une structure 34 de germination favorisant la croissance de fils et recouvrant le substrat 32. La face supérieure de la structure de germination 34 correspond à la face 26 du support 22 décrite précédemment. La structure de germination 34 peut comprendre une seule couche de germination favorisant la croissance de fils ou un empilement de couches, dont au moins la couche supérieure est une couche de germination favorisant la croissance de fils. La structure de germination 34 représentée à titre d'exemple en figure 2 correspond à un empilement de deux couches de germination 36 et 38, la couche 36 étant interposée entre le substrat 32 et la couche de germination 38.

La région absorbante 28 repose sur la structure de germination 34, de préférence au contact de la structure de germination 34. La région absorbante 28 comprend une couche absorbante 40 pour le laser et de préférence au moins une couche intermédiaire 42 interposée entre la couche absorbante 40 et la structure de germination 34. L'absorption de la couche absorbante 40 pour le laser est supérieure à 90 %. Selon un mode de réalisation, le coefficient d'absorption k de la couche absorbante 40 dans le régime linéaire pour la longueur d'onde du laser est compris entre 1 et 10.

La couche absorbante 40 est par exemple en un métal réfractaire ou en un nitrure métallique, notamment du titane (Ti), du tungstène (W), du molybdène (Mo), du tantale (Ta), ou un nitrure de ces métaux, ou un mélange ou alliage d'au moins deux de ces métaux ou de ces nitrures. L'épaisseur de la couche absorbante 40 peut être comprise entre 5 nm et 500 nm. Dans le présent mode de réalisation, la couche intermédiaire 42 fait partie d'une enveloppe isolante 44 entourant complètement la couche absorbante 40. Selon un mode de réalisation, l'épaisseur de la couche intermédiaire 42 est supérieure à 5 nm, par exemple comprise entre 5 nm et 500 nm. La couche intermédiaire 42 est en un matériau isolant, par exemple en dioxyde de silicium ($SiO_2$) ou en nitrure de silicium (SiN). La couche intermédiaire 42, qui peut ne pas être présente, permet d'empêcher que la couche absorbante 40 ne soit en contact mécanique avec la couche supérieure de la structure de germination 34 afin d'éviter la formation d'alliage ou de mélange entre le matériau composant la couche absorbante 40 et la couche supérieure de la structure de germination 34, notamment au cours du procédé de fabrication du circuit optoélectronique 30.

Le circuit optoélectronique 30 comprend au moins un composant optoélectronique tridimensionnel 50, un seul composant optoélectronique tridimensionnel 50 étant représenté en figure 2. Le composant optoélectronique tridimensionnel 50 comprend un fil 52, les autres éléments du composant optoélectronique tridimensionnel 50 n'étant pas représentés en figure 2 et étant décrits plus en détail par la suite. La région absorbante 28 comprend une ouverture 54 pour chaque composant optoélectronique 50. La base 53 du fil 52 repose sur la structure de germination 34 au travers de l'ouverture 54 et est au contact de la structure de germination 34. Le circuit optoélectronique 30 comprend en outre une couche isolante 56 recouvrant la région absorbante 28 et recouvrant une portion inférieure du fil 52. La couche isolante 56 peut notamment s'étendre dans l'ouverture 54 autour du fil 52. La présence de l'enveloppe isolante 44, et éventuellement de la couche isolante 56, entre la couche absorbante 40 et le fil 52 permet notamment d'empêcher une nucléation parasite sur les flancs de la couche absorbante 40 lors de la formation du fil 52.

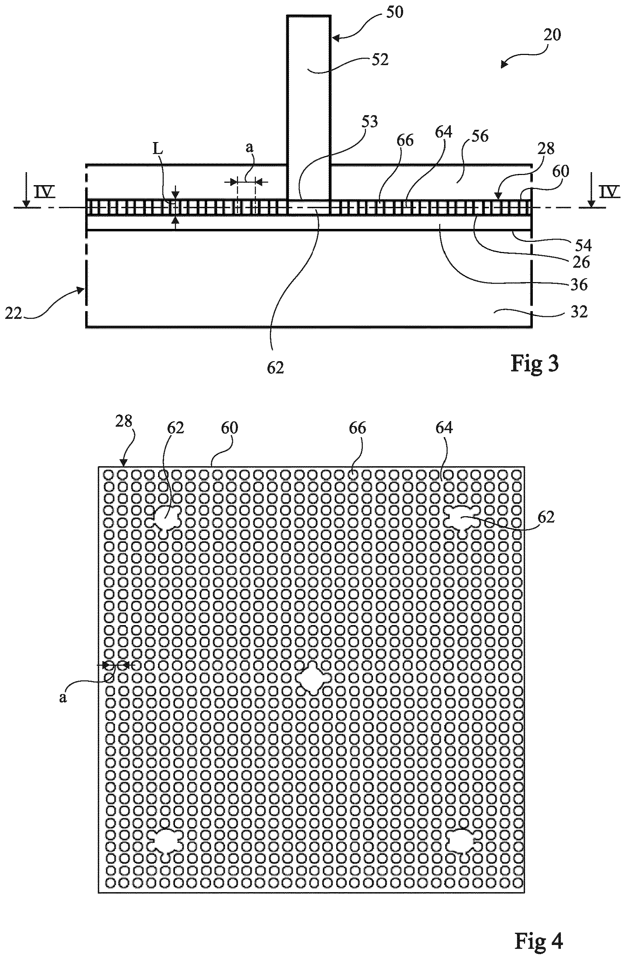

La figure 3 est une vue en coupe agrandie d'un autre mode de réalisation du dispositif 20 et la figure 4 est une vue de dessus avec coupe de la figure 3 selon le plan IV-IV ; cette configuration relève du champ de l'invention telle que revendiquée.

Le dispositif 20 représenté en figure 3 comprend l'ensemble des éléments du dispositif 20 représenté en figure 2 à la différence que la région absorbante 28 comprend un cristal photonique 60. De préférence, le cristal photonique 60 correspond à un cristal photonique à deux dimensions. Selon un mode de réalisation, un mode de propagation du cristal photonique 60 correspond à la longueur d'onde du laser. Dans ce mode de réalisation, l'absorption du laser est réalisée au niveau du cristal photonique 60 par des mécanismes décrits plus en détail par la suite.

De plus, dans le dispositif 20 représenté en figure 2, la structure de germination 34 comprend, pour chaque fil 52, un plot de germination 62 sur lequel repose la base 53 du fil 52 et de préférence au contact de la base 53 du fil 52. La structure de germination 34 peut en outre comprendre la couche 36 sur laquelle reposent les plots de germination 62, de préférence au contact de la couche 36, comme cela est représenté en figure 3, ou comprend un empilement d'au moins deux couches sur lequel reposent les plots de germination 62, de préférence au contact de l'empilement. La face 26 du support 22 correspond dans le présent mode de réalisation à la face supérieure de la structure de germination 34.

Le cristal photonique 60 comprend une couche 64, appelée couche de base par la suite, d'un premier matériau ayant un premier indice de réfraction à la longueur d'onde du laser dans laquelle s'étendent des piliers 66 d'un deuxième matériau ayant un deuxième indice de réfraction à la longueur d'onde du laser. Selon un mode de réalisation, chaque pilier 66 s'étend sensiblement selon un axe central perpendiculaire à la face 26 sur une hauteur L, mesurée perpendiculairement à la face 26. On désignera par "a" (en anglais pitch) la distance entre les axes centraux de deux piliers 66 adjacents. De préférence, le deuxième indice de réfraction est supérieur au premier indice de réfraction. Le premier matériau peut être transparent pour le laser 18. Le premier matériau peut être un matériau isolant. Le deuxième matériau peut être transparent pour le laser 18. Dans le présent mode de réalisation, les piliers 66 sont du même matériau que les plots de germination 62 et sont formés simultanément aux plots de germination 62. Comme cela apparaît sur la figure 4, les plots de germination 62 peuvent alors être en partie fusionnés avec les piliers 66 adjacents. Selon un mode de réalisation, les piliers 66 du cristal photonique 60 peuvent être dans l'un des matériaux décrits précédemment pour la couche absorbante 40. Dans ce cas, les piliers 66 jouent en outre le rôle de la couche absorbante 40 comme cela sera décrit plus en détail par la suite. A titre de variante, la couche de base 64 du cristal photonique 60 est dans l'un des matériaux décrits précédemment pour la couche absorbante 40. Dans ce cas, la couche de base 64 joue en outre le rôle de la couche absorbante 40 comme cela sera décrit plus en détail par la suite.

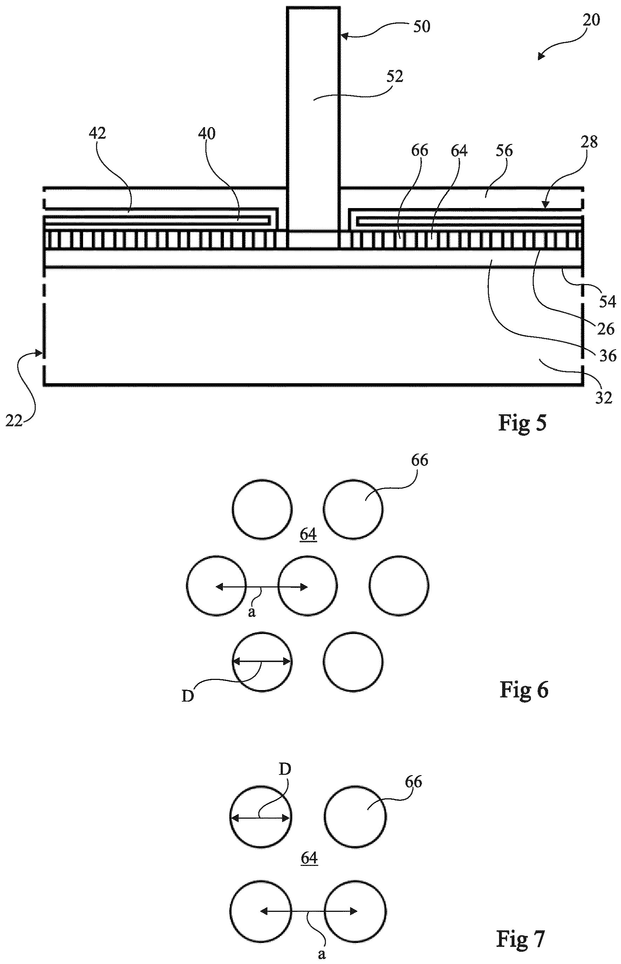

La figure 5 est une vue en coupe agrandie d'un autre mode de réalisation du dispositif 20 ; cette configuration relève du champ de l'invention telle que revendiquée. Le dispositif 20 représenté en figure 5 comprend l'ensemble des éléments du dispositif 20 représenté en figure 3 et l'ensemble des éléments du dispositif 20 représenté en figure 2, c'est-à-dire que la région absorbante 28 comprend la couche absorbante 40 pour le laser et le cristal photonique 60, la couche absorbante 40 étant située du côté du cristal photonique 60 opposé au substrat 32. Comme cela est représenté en figure 5, le dispositif 20 peut comprendre la couche intermédiaire 42 interposée entre la couche absorbante 40 et le cristal photonique 60. A titre de variante, la couche intermédiaire 42 peut ne pas être présente. L'absorption du laser peut être réalisée au niveau de la couche absorbante 40 et également au niveau du cristal photonique 60 par des mécanismes décrits plus en détail par la suite. A titre de variante, l'absorption du laser peut être réalisée seulement au niveau de la couche absorbante 40 et pas au niveau du cristal photonique 60, le cristal photonique 60 permettant alors, comme cela est décrit plus en détail par la suite, à augmenter la durée de présence du laser dans la couche absorbante 40.

Dans les modes de réalisation décrits en relation avec les figures 3 à 5, la hauteur L de chaque pilier 66 peut être comprise entre 100 nm et 1 $\mu$m, de préférence comprise entre 250 nm et 500 nm. La hauteur L des piliers 66 peut être égale à l'épaisseur de la couche de base 64 comme cela est représenté sur les figures 3 et 5. A titre de variante, l'épaisseur de la couche de base 64 peut être supérieure à la hauteur des piliers 66, la couche de base 64 s'étendant entre les piliers 66 et recouvrant alors également les piliers 66.

De préférence, les piliers 66 sont agencés en réseau. Selon un mode de réalisation, le pas a entre chaque pilier 66 et le pilier ou les piliers les plus proches est sensiblement constant.

La figure 6 est une vue agrandie de dessus, partielle et schématique, d'un mode de réalisation du cristal photonique 60 dans lequel les piliers 66 sont agencés selon un réseau hexagonal. Ceci signifie que les piliers 66 sont, dans la vue de dessus, agencés en rangées, les centres des piliers 66 se trouvant aux sommets de triangles équilatéraux, les centres de deux piliers 66 adjacents d'une même rangée étant séparés du pas a et les centres des piliers 66 de deux rangées adjacentes étant décalés de la distance a/2 selon la direction des rangées.

La figure 7 est une vue agrandie de dessus, partielle et schématique, d'un autre mode de réalisation du cristal photonique 60 dans lequel les piliers 66 sont agencés selon un réseau carré. Ceci signifie que les piliers 66 sont agencés en rangées et en colonnes, les centres des piliers 66 se trouvant aux sommets de carrés, deux piliers 66 adjacents d'une même rangée étant séparés du pas a et deux piliers 66 adjacents d'une même colonne étant séparés du pas a.

Dans les modes de réalisation illustrés sur les figures 3 à 7, chaque pilier 66 a une section droite circulaire de diamètre D dans un plan parallèle à la face 26. Dans le cas d'un agencement en réseau hexagonal, le diamètre D peut être compris entre 0,2 $\mu$m et 3,8 $\mu$m. Le pas a peut être compris entre 0,4 $\mu$m et 4 $\mu$m. Dans le cas d'un agencement en réseau carré, le diamètre D peut être compris entre 0,05 $\mu$m et 2 $\mu$m. Le pas a peut être compris entre 0,1 $\mu$m et 4 $\mu$m.

Dans les modes de réalisation illustrés sur les figures 3 à 7, la section droite de chaque pilier 66 est circulaire dans un plan parallèle à la face 26. La section droite des piliers 66 peut toutefois avoir une forme différente, par exemple la forme d'un ovale, d'un polygone, notamment d'un carré, d'un rectangle, d'un hexagone, etc. Selon un mode de réalisation, tous les piliers 66 ont la même section droite.

Des premières et deuxièmes simulations ont été réalisées avec la structure du dispositif 20 représenté en figure 5. Pour les premières simulations, le cristal photonique 60 comprenait des piliers 66 en silicium et la couche de base 64 était en SiO$_2$. Les piliers 66 étaient répartis selon un réseau hexagonal, chaque pilier 66 ayant une section droite circulaire de diamètre D égal à 0,97 $\mu$m. Pour les premières simulations, l'épaisseur L des piliers 66 était égale à 1 $\mu$m. La couche absorbante 40 avait une épaisseur de 50 nm, un indice de réfraction égal à 4,5 et un coefficient d'absorption égal à 3,75.

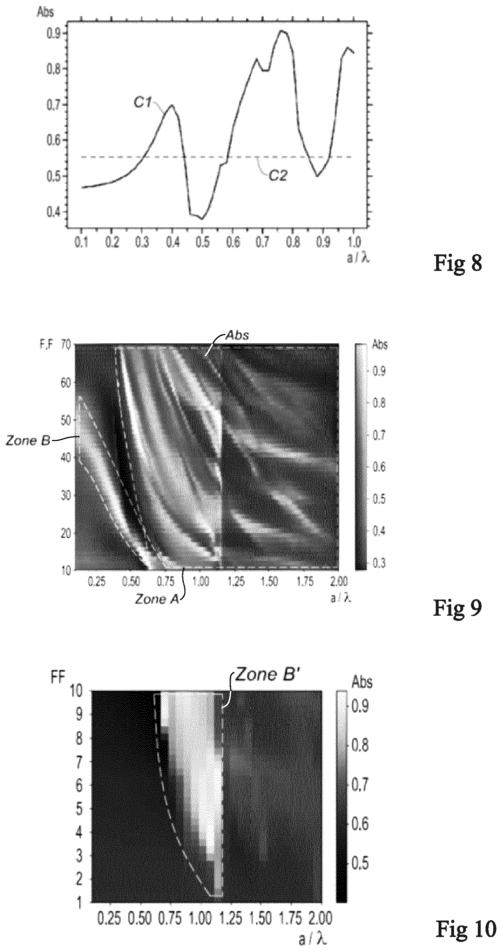

La figure 8 représente des courbes d'évolution C1 et C2 de l'absorption moyenne Abs de la région absorbante 28 en fonction du rapport a/$\lambda$ entre le pas a et la longueur d'onde $\lambda$ du laser, la courbe C1 étant obtenue lorsque le dispositif 20 a la structure représentée sur la figure 5 et la courbe C2 étant obtenue lorsque le dispositif 20 ne comprend pas le cristal photonique 60 mais seulement la couche absorbante 40. En l'absence du cristal photonique 60, l'absorption moyenne dans la région absorbante 28 est d'environ 55 %. En présence du cristal photonique 60, l'absorption moyenne dépasse 55 % sur plusieurs plages du rapport a/$\lambda$ et atteint même 90 % lorsque le rapport a/$\lambda$ est égal à environ 0,75.

Pour les deuxièmes simulations, le cristal photonique 60 comprenait des piliers 66 en silicium et la couche de base 64 était en SiO$_2$. Les piliers 66 étaient répartis selon un réseau hexagonal, chaque pilier 66 ayant une section droite circulaire. Pour les deuxièmes simulations, l'épaisseur L des piliers 66 était égale à 1 μm.

Les figures 9 et 10 représentent chacune une carte de profondeur, en niveaux de gris, de l'absorption moyenne Abs dans la région absorbante 28 en fonction du rapport a/λ en abscisses et du facteur de remplissage FF en ordonnées. Le facteur de remplissage FF correspond au rapport, en vue de dessus, entre la somme des aires des piliers 66 et l'aire totale du cristal photonique 60. A titre d'exemple, pour des piliers 66 de section droite circulaire, le facteur de remplissage FF est donné par la relation [Math 1] suivante :

[Math 1]

$$FF = \frac{3*\left(\frac{D}{2}\right)^2}{a^2}$$

On distingue une zone A et une zone B sur la figure 9 et une zone B' sur la figure 10 pour lesquelles l'absorption moyenne Abs est supérieure à environ 70 %. Les zones B et B' sont obtenues pour un rapport a/λ compris entre 0,1 et 1 et un facteur de remplissage FF compris entre 1 % et 50 % et la zone A est obtenue pour un rapport a/λ compris entre 0,5 et 2 et un facteur de remplissage FF compris entre 10 % et 70 %.

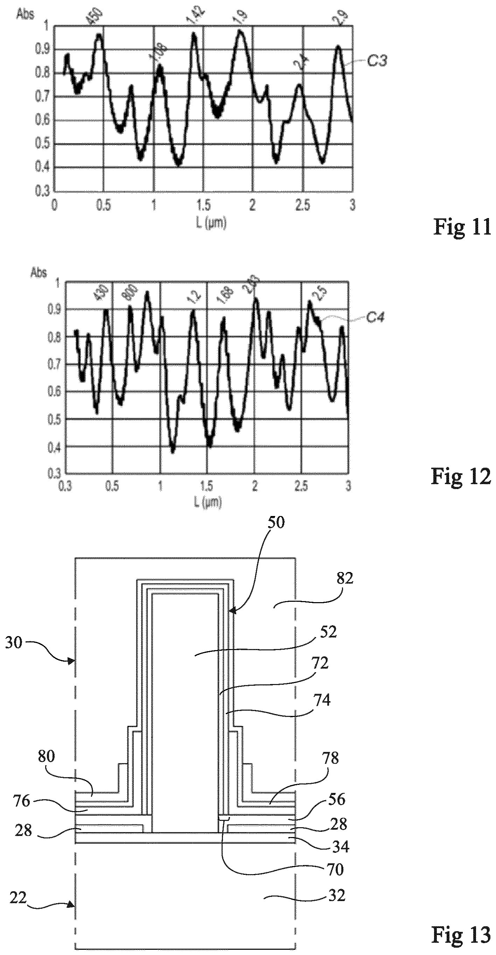

La figure 11 représente une courbe d'évolution C3 de l'absorption moyenne Abs en fonction de la hauteur L des piliers 66 pour un facteur de remplissage FF égal à 0,3 et pour un rapport a/λ égal à 0,6.

La figure 12 représente une courbe d'évolution C4 de l'absorption moyenne Abs en fonction de la hauteur L des piliers 66 pour un facteur de remplissage FF égal à 0,5 et pour un rapport a/λ égal à 0,6.

Les courbes C3 et C4 présentent des maxima locaux qui correspondent à des résonances de Fabry-Pérot à différents ordres, les valeurs correspondantes de la hauteur L étant indiquées sur les figures 11 et 12. Il est préférable de sélectionner la hauteur L des piliers 66 de façon à se trouver sensiblement au niveau de l'une des résonances de Fabry Pérot.

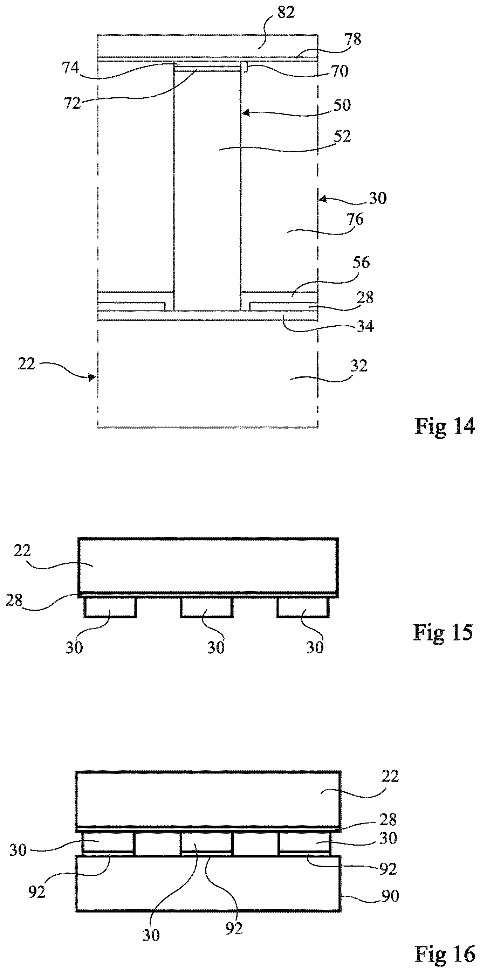

Des modes de réalisation plus détaillés du composant optoélectronique 50 vont être décrits en relation avec les figures 13 et 14 dans le cas où le composant optoélectronique correspond à une diode électroluminescente. Toutefois, il est clair que ces modes de réalisation peuvent concerner d'autres applications, notamment des composants optoélectroniques dédiés à la détection ou la mesure d'un rayonnement électromagnétique ou des composants optoélectroniques dédiés aux applications photovoltaïques.

La figure 13 est une vue en coupe, partielle et schématique, d'un mode de réalisation du composant optoélectronique 50. Le composant optoélectronique 50 comprend une coque 70 recouvrant la paroi extérieure de la portion supérieure du fil 52, la coque 70 comprenant au moins un empilement d'une couche active 72 recouvrant une portion supérieure du fil 52 et d'une couche semiconductrice 74 recouvrant la couche active 72. Dans le présent mode de réalisation, le composant optoélectronique 50 est dit en configuration radiale dans la mesure où la coque 70 recouvre les parois latérales du fil 52. Le circuit optoélectronique 30 comprend en outre une couche isolante 76 qui s'étend sur la couche isolante 56 et sur les parois latérales d'une portion inférieure de la coque 70. Le circuit optoélectronique 30 comprend en outre une couche conductrice 78 recouvrant la coque 70 et formant une électrode, la couche conductrice 76 étant transparente au rayonnement émis par la couche active 72. La couche conductrice 76 peut notamment recouvrir les coques 70 de plusieurs composants optoélectroniques 50 du circuit optoélectronique 30, formant alors une électrode commune à plusieurs composants électroniques 50. Le circuit optoélectronique 30 comprend en outre une couche conductrice 80 s'étendant sur la couche d'électrode 78 entre les fils 52. Le circuit optoélectronique 30 comprend en outre une couche d'encapsulation 82 recouvrant les composants optoélectroniques 30.

La figure 14 est une vue en coupe, partielle et schématique, d'un autre mode de réalisation du composant optoélectronique 50. Le composant optoélectronique 50 représenté en figure 14 comprend l'ensemble des éléments du composant optoélectronique 50 représenté en figure 13 à la différence que la coque 70 n'est présente qu'au sommet du fil 52. Le composant optoélectronique 50 est alors dit en configuration axiale.

Selon un mode de réalisation, les fils 52 sont, au moins en partie, formés à partir d'au moins un matériau semiconducteur. Le matériau semiconducteur est choisi parmi le groupe comprenant les composés III-V, les composés II-VI ou les semiconducteurs ou composés du groupe IV. Les fils 52 peuvent être, au moins en partie, formés à partir de matériaux semiconducteurs comportant majoritairement un composé III-V, par exemple un composé III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. Les fils 52 peuvent être, au moins en partie, formés à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn), le cadmium (Cd) et le mercure (Hg). Des exemples d'éléments du groupe VI comprennent des éléments du groupe VIA, notamment l'oxygène (O) et le tellure (Te). Des exemples de composés II-VI sont ZnO, ZnMgO, CdZnO, CdZnMgO, CdHgTe, CdTe ou HgTe. De façon générale, les éléments dans le composé III-V ou II-VI peuvent être combinés avec différentes fractions molaires. Les fils 52 peuvent être, au moins en partie, formés à partir de matériaux semiconducteurs comportant majoritairement au moins un élément du groupe IV. Des exemples de matériaux semiconducteurs du groupe IV sont le silicium (Si), le carbone (C), le germanium (Ge), les alliages de carbure de silicium (SiC), les alliages silicium-germanium (SiGe) ou les alliages de carbure de germanium (GeC). Les fils 52 peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du soufre (S), du terbium (Tb) ou de l'étain (Sn).

La couche de germination 38, les plots de germination 62, et éventuellement la couche 36 sont en un matériau favorisant la croissance des fils 52. A titre d'exemple, le matériau composant la couche de germination 38, les plots de germination 62, et éventuellement la couche 36 peut être un nitrure, un carbure ou un borure d'un métal de transition de la colonne IV, V ou VI du tableau périodique des éléments ou une combinaison de ces composés. A titre d'exemple, la couche de germination 38, les plots de germination 62, et éventuellement la couche 36 peuvent être en nitrure d'aluminium (AlN), en oxyde d'aluminium ($Al_2O_3$), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borate de zirconium ($ZrB_2$), en nitrure de zirconium (ZrN), en carbure de silicium (SiC), en nitrure et carbure de tantale (TaCN), ou en nitrure de magnésium sous la forme $Mg_xN_y$, où x est environ égal à 3 et y est environ égal à 2, par exemple du nitrure de magnésium selon la forme $Mg_3N_2$.

Chaque couche isolante 42, 56, 54, 76 peut être en un matériau diélectrique, par exemple en oxyde de silicium ($SiO_2$), en nitrure de silicium ($Si_xN_y$, où x est environ égal à 3 et y est environ égal à 4, par exemple du $Si_3N_4$), en oxynitrure de silicium (notamment de formule générale $SiO_xN_y$, par exemple du $Si_2ON_2$), en oxyde d'hafnium ($HfO_2$) ou en diamant.

La couche active 72 peut comporter des moyens de confinement, tels qu'un puits quantique unique ou des puits quantiques multiples. Elle est, par exemple, constituée d'une alternance de couches de GaN et de InGaN ayant des épaisseurs respectives de 5 à 20 nm (par exemple 8 nm) et de 1 à 10 nm (par exemple 2,5 nm). Les couches de GaN peuvent être dopées, par exemple de type N ou P. Selon un autre exemple, la couche active peut comprendre une seule couche d'InGaN, par exemple d'épaisseur supérieure à 10 nm.

La couche semiconductrice 74, par exemple dopée de type P, peut correspondre à un empilement de couches semiconductrices et permet la formation d'une jonction P-N ou P-I-N, la couche active 42 étant comprise entre la couche intermédiaire de type P et le fil 52 de type N de la jonction P-N ou P-I-N.

La couche d'électrode 78 est adaptée à polariser la couche active de la diode électroluminescente et à laisser passer le rayonnement électromagnétique émis par la diode électroluminescente. Le matériau formant la couche d'électrode 78 peut être un matériau transparent et conducteur tel que de l'oxyde d'indium-étain (ou ITO, acronyme anglais pour Indium Tin Oxide), de l'oxyde de zinc pur, de l'oxyde de zinc dopé à l'aluminium de l'oxyde de zinc dopé au gallium, du graphène, ou des nanofils d'argent. A titre d'exemple, la couche d'électrode 78 a une épaisseur comprise entre 5 nm et 200 nm, de préférence entre 30 nm et 100 nm.

La couche d'encapsulation 82 peut être en un matériau organique ou un matériau inorganique et est au moins partiellement transparente au rayonnement émis par la diode électroluminescente. La couche d'encapsulation 82 peut comprendre des luminophores adaptés, lorsqu'ils sont excités par la lumière émis par la diode électroluminescente, à émettre de la lumière à une longueur d'onde différente de la longueur d'onde de la lumière émise par la diode électroluminescente.

Les figures 15 à 18 sont des vues en coupe, partielles et schématiques, des structures obtenues à des étapes successives d'un mode de réalisation d'un procédé de découpe du dispositif 20 au laser.

La figure 15 représente la structure obtenue après la fabrication du dispositif 20, trois circuits optoélectroniques 30 étant représentés à titre d'exemple en figure 15, la région absorbante 28 étant représentée de façon schématique par une couche continue en figure 15.

La figure 16 représente la structure obtenue après la mise en contact du dispositif 20 avec un support 90 entraînant la fixation des circuits optoélectroniques 30 au support 90. Selon un mode de réalisation, la fixation des circuits optoélectroniques 30 au support 90 peut être obtenue par collage moléculaire hydride des circuits optoélectroniques 30 au support 90. Selon un mode de réalisation, le support 90 peut comprendre des plots 92 aux emplacements de fixation des circuits optoélectroniques 30. Le dispositif 20 et le support 90 sont alors rapprochés l'un de l'autre jusqu'à ce que les circuits optoélectroniques 30 viennent au contact des plots 92. Selon un mode de réalisation, tous les circuits optoélectroniques 30 fixés au support 22 ne sont pas destinés à être transférés sur un même support 90. Dans ce but, le support 90 peut comprendre des plots 92 seulement pour les circuits optoélectroniques 30 devant être transférés sur le support 90. Dans ce cas, lorsque le dispositif 20 et le support 90 sont rapprochés l'un de l'autre jusqu'à ce que certains des circuits optoélectroniques 30 viennent au contact des plots 92, les circuits optoélectroniques 30 qui ne sont pas en vis-à-vis d'un plot 92 ne sont pas au contact du support 90 et ne sont donc pas fixés au support 90.

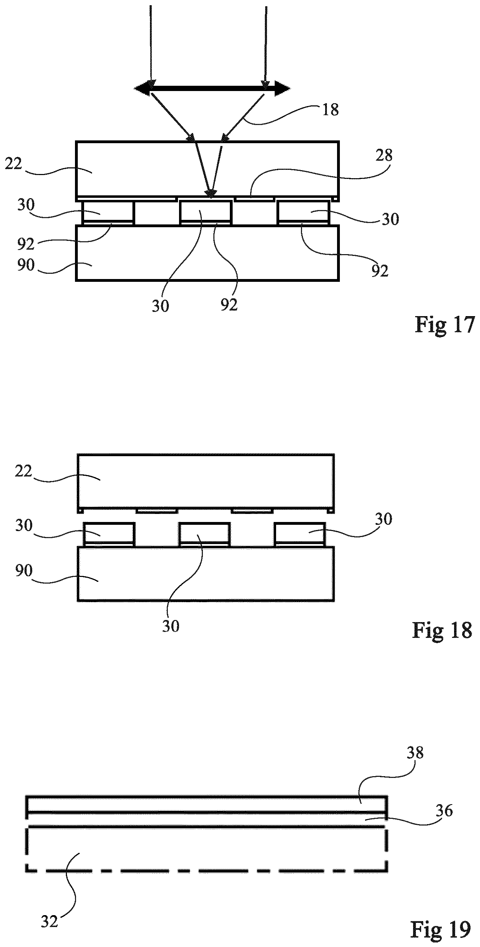

La figure 17 représente la structure obtenue au cours du passage du laser 18 pour détacher du support 22 les circuits optoélectroniques 30 devant être transférés sur le support 90. En fonctionnement, le faisceau laser 18 est de préférence focalisé sur la région absorbante 28, de façon à obtenir l'ablation de la région absorbante 28. Dans le mode de réalisation représenté en figure 2, le laser 18 est directement absorbé par la couche absorbante 40. Dans les modes de réalisation représentés sur les figures 3 et 4, lorsque les piliers 66 ou la couche de base 64 est en un matériau absorbant le laser 18, le cristal photonique 60 permet en particulier d'augmenter l'absorption de la lumière du laser dans les piliers 66 ou dans la couche de base 64. Ceci permet d'obtenir l'ablation du cristal photonique 60. Lorsque ni le matériau composant les piliers 66 du cristal photonique 60, ni le matériau composant la couche de base 64 du cristal photonique 60 n'a un coefficient d'absorption k compris entre 1 et 10 à la longueur d'onde du laser en régime linéaire, le cristal photonique 60 permet d'augmenter le temps de présence des photons du laser dans le cristal photonique 60 et permet donc d'augmenter localement la densité d'énergie dans le cristal photonique 60. Ceci permet d'augmenter l'absorption du laser par des phénomènes d'absorption non-linéaires dans le cristal photonique 60, ce qui entraîne l'ablation du cristal photonique 60. La présence du cristal photonique 60 permet alors de réduire l'intensité du laser pour laquelle les phénomènes d'absorption non-linéaires apparaissent notamment avec les matériaux composant la couche de base 64 et les piliers 66. Dans le mode de réalisation représenté en figure 5, le cristal photonique 60 permet d'augmenter localement la densité d'énergie dans la couche absorbante 40. Ceci permet d'obtenir l'ablation de la couche absorbante 40. L'absorption du laser peut en outre être directement réalisée au niveau du cristal photonique 60 selon les phénomènes décrits précédemment.

Lorsque le support 22 est en un matériau semiconducteur, notamment en silicium, il peut être nécessaire que la longueur d'onde du laser soit dans la bande infrarouge, de façon que le support 22 soit transparent au laser. Toutefois, les lasers infrarouges disponibles dans le commerce présentent généralement une énergie maximale plus faible que d'autres lasers disponibles dans le commerce à d'autres fréquences. Les modes de réalisation du dispositif 20 décrits précédemment permettent de façon avantageuse de réaliser une découpe laser même avec un laser infrarouge, et permettent donc de façon avantageuse l'utilisation de support 22 semiconducteur, en particulier en silicium.

La figure 18 représente la structure obtenue après l'éloignement du support 22 par rapport au support 90. Les circuits optoélectroniques 30 fixés au support 90 sont détachés du support 22.

Les figures 19 à 25 sont des vues en coupe, partielles et schématiques, des structures obtenues à des étapes successives d'un mode de réalisation d'un procédé de fabrication du dispositif 20 tel que représenté en figure 3. Le procédé de fabrication comprend les étapes suivantes :

- formation de la structure de germination 34 sur le substrat 32 (figure 19), une structure de germination 34 comprenant un empilement de deux couches 36 et 38 étant représentée à titre d'exemple sur la figure 19 ;

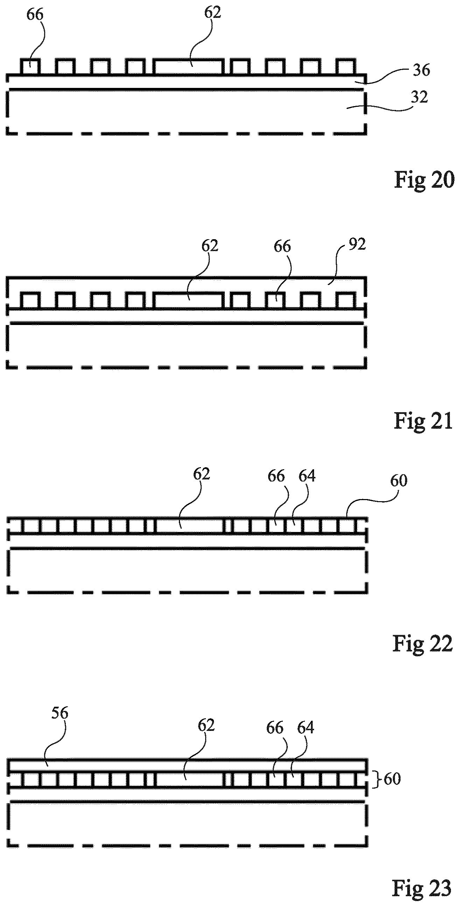

- gravure des piliers 66 du cristal photonique et des plots de germination 62 dans la couche supérieure 38 de la structure de germination 34 (figure 20) par exemple sur la totalité de l'épaisseur 36 de la couche supérieure 38, la couche 36 pouvant alors jouer le rôle de couche d'arrêt de gravure ;

- dépôt d'une couche 92 du premier matériau recouvrant la structure de germination 34 et remplissant notamment les ouvertures entre les piliers 66 et autour des plots de germination 62 (figure 21) ;

- gravure de la couche 92 jusqu'à atteindre le sommet des piliers 66 et des plots de germination 62, par exemple par planarisation chimico-physique (CMP, sigle anglais pour Chemical-Mechanical Planarization), pour ne conserver que la portion de la couche 92 entre les piliers 66 et autour des plots de germination 62, formant ainsi notamment la couche de base 64 du cristal photonique 60 (figure 22) ;

- formation de la couche isolante 56 sur le cristal photonique 60 (figure 23) ;

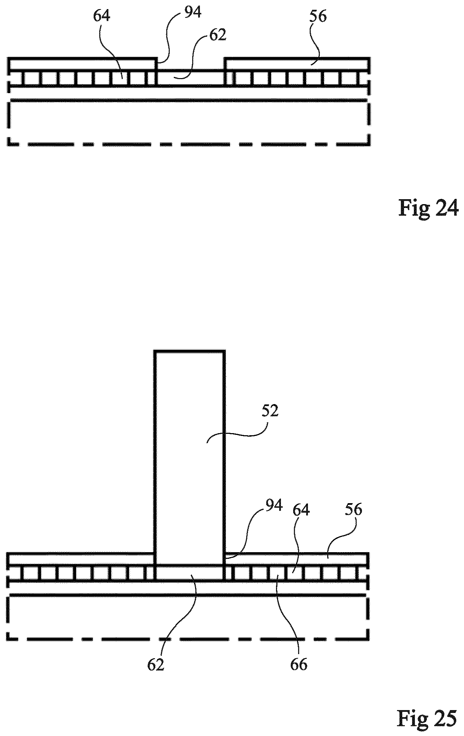

- gravure d'ouvertures 94 dans la couche isolante 56 pour exposer les sommets de piliers 66 du cristal photonique 60 aux emplacements souhaités de formation des composants optoélectroniques (figure 24) ; et

- croissance, dans chaque ouverture 94, d'un fil 52 (figure 25), les piliers 66 jouant le rôle de plot de germination.

Le procédé de fabrication du dispositif 20 se poursuit par les étapes de formation des composants optoélectroniques.

Selon les matériaux utilisés, les étapes de dépôt dans le mode de réalisation décrit précédemment peuvent être un procédé du type dépôt chimique en phase vapeur (CVD, sigle anglais pour Chemical Vapor Deposition) ou dépôt chimique en phase vapeur aux organométalliques (MOCVD, acronyme anglais pour Metal-Organic Chemical Vapor Deposition), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy) ou l'épitaxie en phase vapeur aux hydrures (HVPE, acronyme anglais pour Hydride Vapor Phase Epitaxy) peuvent être utilisés. Toutefois, des procédés électrochimiques peuvent être utilisés, par exemple, le dépôt en bain chimique (CBD, sigle anglais pour Chemical Bath Deposition), les procédés hydrothermiques, la pyrolyse d'aérosol liquide ou l'électrodépôt.

Un mode de réalisation d'un procédé de fabrication du dispositif 20 représenté en figure 2 comprend les mêmes étapes que celles décrites précédemment en relation avec les figures 19 à 25 à la différence que les étapes de formation du cristal photonique 60 sont remplacées par des étapes de dépôt de la couche intermédiaire 42 et de la couche absorbante 40.

L'invention est définie par les revendications annexées.

## Revendications

1. Dispositif (20) configuré pour un traitement au laser (18), comprenant un support (22) transparent pour le laser et au moins un circuit optoélectronique (30) comprenant au moins un composant optoélectronique (50) ayant un élément semiconducteur tridimensionnel (52) recouvert d'une couche active (72), l'élément semiconducteur tridimensionnel étant un microfil, un nanofil, un élément conique de taille micrométrique ou nanométrique, ou un élément tronconique de taille micrométrique ou nanométrique, l'élément semiconducteur tridimensionnel comprenant une base (53) fixée au support (22), le support (22) comprenant un substrat (32) transparent pour le laser et un plot (62) en un deuxième matériau favorisant la croissance de l'élément semiconducteur tridimensionnel (52) interposé entre le substrat (32) et la base (53) de l'élément semiconducteur tridimensionnel (52), le dispositif comprenant une région (28) absorbante pour le laser reposant sur le support (22) et entourant la base (53), **caractérisé par**
la région absorbante (28) comprenant un cristal photonique (60), le cristal photonique (60) comprenant une couche de base (64) d'un premier matériau et un réseau de piliers (66) dudit deuxième matériau différent dudit premier matériau.

2. Dispositif selon la revendication **1,** dans lequel le cristal photonique (60) est un cristal photonique à deux dimensions.

3. Dispositif selon la revendication 1 ou 2, dans lequel chaque pilier s'étend dans la couche de base (64) sur au moins une partie de l'épaisseur de la couche de base (64).

4. Dispositif selon l'une quelconque des revendications précédentes, dans lequel le premier matériau a un coefficient d'absorption pour le laser (18) inférieur à 1.

5. Dispositif selon l'une quelconque des revendications précédentes, dans lequel le premier matériau a un coefficient d'absorption pour le laser (18) compris entre 1 et 10.

6. Dispositif selon l'une quelconque des revendications précédentes, dans lequel le deuxième matériau a un coefficient d'absorption pour le laser (18) inférieur à 1.

7. Dispositif selon l'une quelconque des revendications précédentes, dans lequel la région absorbante (28) comprend une couche absorbante (40) entourant la base (53), la couche absorbante (40) étant en un troisième matériau ayant un coefficient d'absorption pour le laser (18) compris entre 1 et 10.

8. Dispositif selon la revendication 7, comprenant une couche isolante électriquement (42) interposée entre la couche absorbante (40) et le support (22).

9. Dispositif selon la revendication 7 ou 8, comprenant une couche isolante électriquement (42) interposée entre la couche absorbante (40) et l'élément semiconducteur tridimensionnel (52).

10. Dispositif selon l'une quelconque des revendications 1 à 9, dans lequel la région absorbante (28) entoure le plot (62).

11. Dispositif selon l'une quelconque des revendications 1 à 10, dans lequel le deuxième matériau est un nitrure, un carbure ou un borure d'un métal de transition de la colonne IV, V ou VI du tableau périodique des éléments ou une combinaison de ces composés ou dans lequel le deuxième matériau est du nitrure d'aluminium, de l'oxyde d'aluminium, du bore, du nitrure de bore, du titane, du nitrure de titane, du tantale, du nitrure de tantale, de l'hafnium, du nitrure d'hafnium, du niobium, du nitrure de niobium, du zirconium, du borate de zirconium, du nitrure de zirconium, du carbure de silicium, du nitrure et carbure de tantale, du nitrure de magnésium ou un mélange d'au moins deux de ces composés.

12. Dispositif selon l'une quelconque des revendications 1 à 11, comprenant plusieurs exemplaires du composant optoélectronique (50), les bases (53) desdits composants optoélectroniques (50) étant fixées au support (22).

13. Procédé de fabrication du dispositif (20) selon l'une quelconque des revendications 1 à 12, comprenant la croissance par épitaxie de l'élément semiconducteur tridimensionnel (52) sur le support (22).

14. Procédé de traitement au laser (18) du dispositif (20) selon l'une quelconque des revendications 1 à 12, le procédé comprenant l'exposition de la région absorbante (28) au faisceau laser (18) au travers du support (22).

15. Procédé selon la revendication 14, comprenant la fixation du circuit optoélectronique (30) à un réceptacle (90), le circuit optoélectronique étant encore relié au support (22) et la destruction d'au moins une partie de la région absorbante (28) par le laser (18).

**Patentansprüche**

1. Vorrichtung (20) konfiguriert für eine Behandlung mit einem Laser (18), aufweisend einen für den Laser transparenten Träger (22) und mindestens einer optoelektronischen Schaltung (30), die mindestens ein optoelektronisches Bauelement (50) mit einem dreidimensionalen Halbleiterelement (52) aufweist, das mit einer aktiven Schicht (72) bedeckt ist, wobei das dreidimensionale Halbleiterelement ein Mikrodraht, ein Nanodraht, ein konisches Element im Mikrometer- oder Nanometerbereich oder ein sich verjüngendes Element im Mikrometer- oder Nanometerbereich ist, wobei das dreidimensionale Halbleiterelement eine Basis (53) aufweist, die an den Träger (22) gebunden ist, wobei der Träger (22) ein Substrat (32), das für den Laser transparent ist, und eine Auflage (62) aufweist, die aus einem zweiten Material besteht, das das Wachstum des dreidimensionalen Halbleiterelements (52) begünstigt und zwischen dem Substrat (32) und der Basis (53) des dreidimensionalen Halbleiterelements (52) angeordnet ist, wobei die Vorrichtung einen Bereich (28) aufweist, der für den Laser absorbierend ist, auf dem Träger aufliegt und die Basis umgibt, **dadurch gekennzeichnet, dass** der absorbierende Bereich (28) einen photonischen Kristall (60) aufweist, wobei der photonische Kristall (60) eine Basisschicht (64) aus einem ersten Material und ein Gitter aus Säulen (66) aus dem zweiten Material, das sich vom ersten Material unterscheidet, aufweist.

2. Vorrichtung nach Anspruch 1, wobei der photonische Kristall (60) ein zweidimensionaler photonischer Kristall ist.

3. Vorrichtung nach Anspruch 1 oder 2, wobei sich jede Säule in der Basisschicht (64) über mindestens einen Teil der Dicke der Basisschicht (64) erstreckt.

4. Vorrichtung nach einem der vorhergehenden Ansprüche, wobei das erste Material einen Absorptionskoeffizienten für den Laser (18) von kleiner als 1 aufweist.

5. Vorrichtung nach einem der vorhergehenden Ansprüche, wobei das erste Material einen Absorptionskoeffizienten für den Laser (18) im Bereich von 1 bis 10 aufweist.

6. Vorrichtung gemäß einem der vorhergehenden Ansprüche, wobei das zweite Material einen Absorptionskoeffizienten für die Schicht (18) von kleiner als 1 aufweist.

7. Vorrichtung gemäß einem der vorhergehenden Ansprüche, wobei der absorbierende Bereich (28) eine Absorptionsschicht (40) aufweist, die die Basis (53) umgibt, wobei die Absorptionsschicht (40) aus einem dritten Material mit einem Absorptionskoeffizienten für den Laser (18) im Bereich von 1 bis 10 besteht.

8. Vorrichtung nach Anspruch 7, die eine elektrisch isolierende Schicht (42) aufweist, die zwischen der absorbierenden Schicht (40) und dem Träger (22) angeordnet ist.

9. Vorrichtung nach Anspruch 7 oder 8, die eine elektrisch isolierende Schicht (42) aufweist, die zwischen der absorbierenden Schicht (40) und dem dreidimensionalen Halbleiterelement (52) angeordnet ist.

10. Vorrichtung gemäß einem der Ansprüche 1 bis 9, wobei der absorbierende Bereich (28) die Kontaktstelle (62) umgibt.

11. Vorrichtung gemäß einem der Ansprüche 1 bis 10, wobei das zweite Material ein Nitrid, ein Carbid oder ein Borid eines Übergangsmetalls der Spalte **IV,** V oder **VI** des Periodensystems der Elemente oder eine Kombination dieser Verbindungen ist oder wobei das zweite Material Aluminiumnitrid, Aluminiumoxid, Bor, Bornitrid, Titan, Titannitrid, Tantal, Tantalnitrid, Hafnium, Hafniumnitrid, Niob, Niobnitrid, Zirkonium, Zirkoniumborat, Zirkoniumnitrid, Siliciumcarbid, Tantalkohlenstoffnitrid, Magnesiumnitrid oder eine Mischung aus mindestens zwei dieser Verbindungen ist.

12. Vorrichtung gemäß einem der Ansprüche 1 bis 11, die eine Vielzahl von Kopien des optoelektronischen Bauteils (50) aufweist, wobei die Basen (53) der optoelektronischen Bauteile (50) an den Träger (22) gebondet sind.

13. Verfahren zur Herstellung der Vorrichtung (20) gemäß einem der Ansprüche 1 bis 12, aufweisend das epitaktische Aufwachsen des dreidimensionalen Halbleiterelements (52) auf dem Träger (22).

**14.** Verfahren zur Behandlung mit einem Laser (18) der Vorrichtung (20) gemäß einem der Ansprüche 1 bis 12, wobei das Verfahren das Aussetzen des absorbierenden Bereichs (28) gegenüber dem Laserstrahl (18) durch den Träger (22) hindurch aufweist.

**15.** Verfahren nach Anspruch 14, aufweisend das Bonden der optoelektronischen Schaltung (30) an eine Aufnahme (90), während die optoelektronische Schaltung noch mit dem Träger (22) gekoppelt ist, und das Zerstören mindestens eines Teils des absorbierenden Bereichs (28) durch den Laser (18).

**Claims**

**1.** A device (20) configured for a treatment with a laser (18), comprising a support (22) transparent for the laser and at least one optoelectronic circuit (30) comprising at least one optoelectronic component (50) having a three-dimensional semiconductor element (52) covered with an active layer (72), the three-dimensional semiconductor element being a microwire, a nanowire, a micrometer-range or nanometer-range conical element, or a micrometer-range or nanometer-range tapered element, the three-dimensional semiconductor element comprising a base (53) bonded to the support (22), the support (22) comprising a substrate (32) transparent for the laser and a pad (62) made of a second material favoring the growth of the three-dimensional semiconductor element (52) interposed between the substrate (32) and the base (53) of the three-dimensional semiconductor element (52), the device comprising a region (28) absorbing for the laser resting on the support and surrounding the base,
**characterized by** the absorbing region (28) comprising a photonic crystal (60), the photonic crystal (60) comprising a base layer (64) of a first material and a grating of pillars (66) of said second material different from the first material.

**2.** Device according to claim 1, wherein the photonic crystal (60) is a two-dimensional photonic crystal.

**3.** Device according to claim 1 or 2, wherein each pillar extends in the base layer (64) across at least part of the thickness of the base layer (64).

**4.** Device according to any preceding claims, wherein the first material has an absorption coefficient for the laser (18) smaller than 1.

**5.** Device according to any preceding claims, wherein the first material has an absorption coefficient for the laser (18) in the range from 1 to 10.

**6.** Device according to any preceding claims, wherein the second material has an absorption coefficient for the layer (18) smaller than 1.

**7.** Device according to any preceding claims, wherein the absorbing region (28) comprises an absorbing layer (40) surrounding the base (53), the absorbing layer (40) being made of a third material having an absorption coefficient for the laser (18) in the range from 1 to 10.

**8.** Device according to claim 7, comprising an electrically-insulating layer (42) interposed between the absorbing layer (40) and the support (22).

**9.** Device according to claim 7 or 8, comprising an electrically-insulating layer (42) interposed between the absorbing layer (40) and the three-dimensional semiconductor element (52).

**10.** Device according to any of claims 1 to 9, wherein the absorbing region (28) surrounds the pad (62).

**11.** Device according to any of claims 1 to 10, wherein the second material is a nitride, a carbide, or a boride of a transition metal of column IV, V, or VI of the periodic table of elements or a combination of these compounds or wherein the second material is aluminum nitride, aluminum oxide, boron, boron nitride, titanium, titanium nitride, tantalum, tantalum nitride, hafnium, hafnium nitride, niobium, niobium nitride, zirconium, zirconium borate, zirconium nitride, silicon carbide, tantalum carbonitride, magnesium nitride, or a mixture of at least two of these compounds.

**12.** Device according to any of claims 1 to 11, comprising a plurality of copies of the optoelectronic component (50), the bases (53) of said optoelectronic components (50) being bonded to the support (22).

**13.** Method of manufacturing the device (20) according to any of claims 1 to 12, comprising epitaxially growing the three-dimensional semiconductor element (52) on the support (22).

**14.** Method of treatment with a laser (18) of the device (20) according to any of claims 1 to 12, the method comprising exposing the absorbing region (28) to the laser beam (18) through the support (22).

**15.** Method according to claim 14, comprising bonding the optoelectronic circuit (30) to a receptacle (90), the optoelectronic circuit being still coupled to the support (22), and the destruction of at least a portion of the absorbing region (28) by the laser (18).

Fig 1

Fig 2

Fig 3

Fig 4

Fig 5

Fig 6

Fig 7

Fig 8

Fig 9

Fig 10

Fig 11

Fig 12

Fig 13

Fig 14

Fig 15

Fig 16

Fig 17

Fig 18

Fig 19

Fig 20

Fig 21

Fig 22

Fig 23

64    94    56
     62

**Fig 24**

52

94  64  56

62        66

**Fig 25**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 1915605
- US 2019363069 A1
- US 2015279903 A1